# EUROPEAN PATENT APPLICATION

(11) **EP 4 848 587 A1**
(43) Date of publication of application: **02.12.2026**
(21) Application number: 24920663.2
(22) Date of filing: 03.07.2024
(51) Int. Cl.: H03H 11/04, H03H 11/44, H02J 50/10

(54) **RADIOACTIVE NOISE REDUCTION DEVICE FOR COMPENSATING FOR ELECTROMAGNETIC INTERFERENCE**

(30) Priority: 24.01.2024 KR 20240011145
(71) Applicant: Emcoretech Inc., Ulsan 44919 (KR)
(72) Inventor: JEONG, Sang Yeong, Ulju-gun Ulsan 44919 (KR)
(74) Representative: HGF
(86) International application number: PCT/KR2024/009431
(87) International publication number: WO 2025/159247

(57) **Abstract**

According to an embodiment of the present invention, provided is a radioactive noise reduction device for compensating for electromagnetic interference generated by a radioactive source, the radioactive noise reduction device comprising: a compensation unit which includes a compensation loop through which all or a portion of radioactive noise emitted from the source passes; and a circuit unit which is connected to the compensation unit and includes one or more inductors and one or more amplification units. As an impedance of the circuit unit, an input impedance (Zin) viewed from the compensation unit is a value obtained by negatively converting the impedance of the compensation unit.

## Description

### Technical Field

The following embodiments relate to an active radiated noise reduction device for compensating for electromagnetic interference generated by a radiated noise source.

### Background Art

Recently, in response to demands for home appliances, industrial electronic devices, and information and communication devices to have a small size, fast processing capability, and low power consumption, circuits have become miniaturized and sophisticated. Accordingly, as more circuits are installed in a narrow space, circuits have gradually become more susceptible to electromagnetic signals or electrical noise, that is, electromagnetic noise. A state in which such unnecessary electromagnetic noise interferes with the operation of another device or system is referred to as electromagnetic interference (EMI).

Electromagnetic noise causing electromagnetic interference may be classified into conducted noise and radiated noise according to a transmission path. Conducted noise refers to a case in which electromagnetic noise is transmitted through an electrical circuit, and may be noise transmitted through a wire or a cable. In contrast, radiated noise refers to a case in which an electromagnetic wave is wirelessly propagated through air or another medium and affects another device. Such radiated noise is not only harmful to the human body, but also causes a malfunction or failure of another connected electronic device. In particular, low-frequency radiated noise is also classified as a possible carcinogen to humans and is managed under electromagnetic wave standards.

Meanwhile, wireless power transfer (WPT) and induction heating (IH) systems are technologies for wirelessly transferring power through space without using wires. Wireless power transfer may supply power to an electronic device by transmitting electrical energy using electromagnetic waves or a magnetic field without using electric wires. Wireless power transfer and induction heating may basically operate based on a magnetic resonance principle for direct energy transfer, such as an induced current principle or an electromagnetic wave principle. In both wireless power transfer and induction heating technologies, a coil is inevitably exposed outside an enclosure for efficient power transfer, and this structure may become a main cause of radiated noise emissions.

### Disclosure of Invention

### Technical Problem

An object of the present disclosure is to provide an active radiated noise reduction device for compensating for electromagnetic interference generated by a radiated noise source.

The problems to be solved by the present disclosure are not limited to the above-mentioned problems, and other problems and advantages of the present disclosure that are not mentioned may be understood from the following description and may be more clearly understood from the embodiments of the present disclosure. It will also be appreciated that the problems to be solved and the advantages of the present disclosure may be realized by the means and combinations thereof indicated in the claims.

### Solution to Problem

According to an embodiment of the present disclosure, there is provided a radiated noise reduction device for compensating for electromagnetic interference generated by a radiated noise source, the radiated noise reduction device including a compensation part including a compensation loop through which all or a portion of radiated noise emitted from the source passes, and a circuit part connected to the compensation part and including one or more inductors and one or more amplifiers, wherein an input impedance Zin of the circuit part has a value obtained by negatively converting an impedance of the compensation part.

In the present disclosure, the compensation loop may be provided to surround a portion or all of the radiated noise source such that at least a portion of the radiated noise emitted from the source passes through a planar or three-dimensional space inside a loop formed by the compensation loop.

In the present disclosure, the radiated noise reduction device may be located on the same circuit board as the source, and the compensation loop may be provided in a form that surrounds the radiated noise source.

In the present disclosure, a current flowing through the compensation part may be a current that generates a cancellation magnetic field having a direction opposite to a direction of the radiated noise passing through the compensation loop.

In the present disclosure, the circuit part may include a target part including the one or more inductors, and an amplification part connected between the compensation part and the target part and including the one or more amplifiers.

In the present disclosure, the amplification part may include two Op-amps, positive input terminals of the two Op-amps may respectively be connected to opposite ends of the target part, negative input terminals of the two Op-amps may respectively be connected to opposite ends of the compensation part, and an input impedance Zin may be calculated based on resistors Rf1 and Rf2, which are connected to the input terminals of the two Op-amps, and an impedance Zt of the target part.

In the present disclosure, the positive input terminals of the two Op-amps may be connected to the target part and first resistors Rf1, the negative input terminals of the two Op-amps may be connected to the compensation part and second resistors Rf2, output terminals of the two Op-amps may be connected to the first resistors Rf1 and the second resistors Rf2, and the input impedance Zin may satisfy Zin = -(Rf2/Rf1)*Zt.

In the present disclosure, the amplification part may include one Op-amp, a positive input terminal of the Op-amp may be connected to one end of the target part and one end of the compensation part, a negative input terminal of the Op-amp may be connected to a first on-resistance Z₁ and a second on-resistance Z₂, and when an output terminal of the Op-amp is connected to the first on-resistance Z₁ and another end of the target part, the input impedance Zin satisfies Zin = -(Z1/Z2)*Zt.

In the present disclosure, the compensation part of the radiated noise reduction device may be provided such that all or a portion of radiated noise emitted from either a transmitter (Rx)-side coil or a receiver (Rx)-side coil of a wireless power transfer system passes through the compensation part.

### Advantageous Effects of Invention

According to an embodiment of the present disclosure, electromagnetic interference generated by a radiated noise source can be actively compensated for.

In addition, according to an embodiment of the present disclosure, a device capable of canceling radiated noise generated by a radiated noise source can be provided.

In addition, according to an embodiment of the present disclosure, a circuit including a negative impedance converter and configured to generate a cancellation magnetic field for canceling an external magnetic field can be provided.

### Brief Description of Drawings

FIG. 1 illustrates a radiated noise source that emits radiated noise according to an embodiment of the present disclosure.
FIG. 2 is a diagram illustrating an active radiated noise reduction device according to an embodiment of the present disclosure.
FIG. 3 illustrates operations of the radiated noise reduction device and the radiated noise source according to an embodiment of the present disclosure.
FIGS. 4A to 6B are views illustrating active radiated noise reduction devices according to other embodiments of the present disclosure.
FIG. 7 is a block diagram illustrating the radiated noise reduction device according to an embodiment.
FIGS. 8 and 9 illustrate a radiated noise reduction device according to a first embodiment of the present disclosure.
FIGS. 10 and 11 illustrate a radiated noise reduction device according to a second embodiment of the present disclosure.
FIGS. 12 and 13 illustrate a radiated noise reduction device according to a third embodiment of the present disclosure.
FIG. 14 illustrates an example in which shielding structures are used to reduce radiated noise.
FIGS. 15 and 16 are views illustrating an example in which the radiated noise reduction device according to an embodiment of the present disclosure is applied to a wireless power transfer system.
FIGS. 17A and 17B illustrate examples in which the radiated noise reduction device according to an embodiment of the present disclosure is applied to actual products.

### Mode for the Invention

The advantages and features of the present disclosure and methods of achieving them will be apparent from the embodiments that will be described in detail with reference to the accompanying drawings. However, the present disclosure is not limited to the embodiments set forth below, but may be implemented in various different forms, and should be understood to include all modifications, equivalents, and substitutes within the spirit and technical scope of the present disclosure.

The terms used herein are for the purpose of describing particular embodiments only and are not intended to be limiting to the present disclosure. A singular expression includes a plural expression unless the context clearly indicates otherwise. In the present application, it will be further understood that the terms "comprise", "comprising", "include", and/or "including", when used in this specification, specify the presence of stated features, integers, steps, operations, elements, components and/or groups thereof but do not preclude the presence or addition of one or more other features, integers, steps, operations, elements, components and/or groups thereof.

Some embodiments of the disclosure may be represented by functional block configurations and various processing operations. Some or all of these functional blocks may be implemented by various numbers of hardware and/or software configurations that perform particular functions. For example, the functional blocks of the present disclosure may be implemented by one or more microprocessors or by circuit configurations for a certain function. In addition, for example, the functional blocks of the present disclosure may be implemented in various programming or scripting languages. The functional blocks may be implemented by algorithms executed in one or more processors. In addition, the present disclosure may employ conventional techniques for electronic environment setting, signal processing, and/or data processing. Terms such as "mechanism," "element," "means," and "configuration" may be used broadly and are not limited to mechanical and physical configurations.

In addition, connection lines or connection members between components shown in the drawings merely exemplarily illustrate functional connections and/or physical or circuit connections. In an actual device, connections between components may be represented by various functional connections, physical connections, or circuit connections that are replaceable or added.

Hereinafter, the present disclosure will be described in detail with reference to the accompanying drawings.

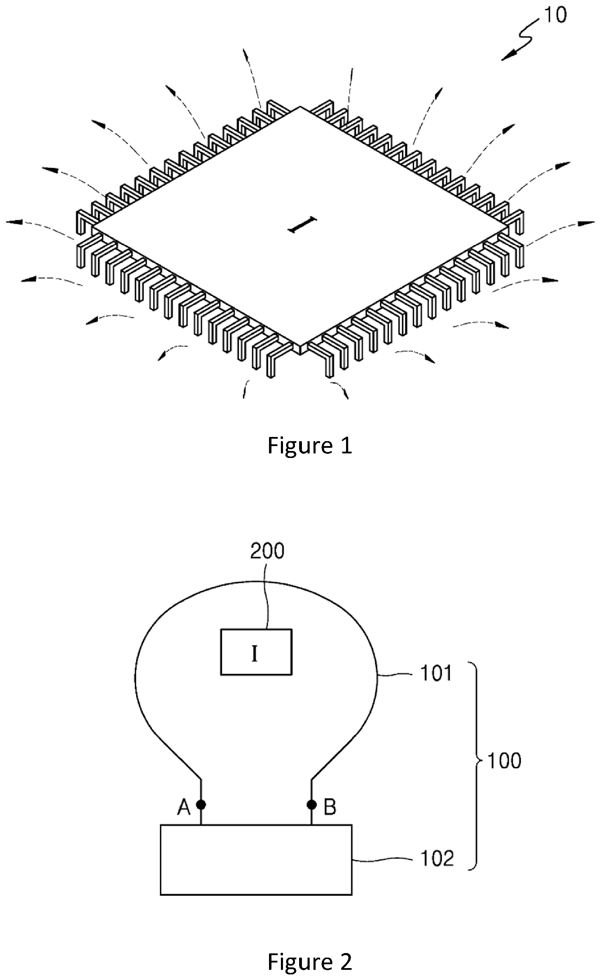

FIG. 1 illustrates a radiated noise source that emits radiated noise according to an embodiment of the present disclosure.

FIG. 1 illustrates, by way of example, a radiated noise source 200 present inside an electronic device 10. The radiated noise source 200 may include a source current source I and may be referred to as a noise source that generates radiated noise during operation of the electronic device 10. Although FIG. 1 illustrates the radiated noise as being indicated by dotted arrows and radiated around the source 200, the present disclosure is not limited thereto, and the radiated noise may be emitted without clear directivity in a vertical direction or a horizontal direction.

Such radiated noise (radiated emissions (RE)) may generally also be referred to as electromagnetic noise. Recently, as various electronic devices have become faster and more highly integrated, cases have occurred in which electronic devices are difficult to ship as commercial products due to electromagnetic interference (EMI) caused by radiated noise.

Accordingly, conventionally, a method of physically shielding a radiated noise source has been used to reduce emission of radiated noise. However, such a physical shielding method has a problem in that it is difficult to effectively block radiated noise, particularly low-frequency electromagnetic waves. In addition, the physical shielding method is costly and has spatial limitations because a thick shielding material is required to increase shielding efficiency.

Accordingly, according to an embodiment of the present disclosure, a method of effectively compensating for electromagnetic interference using an active radiated noise reduction device may be provided.

FIG. 2 is a diagram illustrating an active radiated noise reduction device according to an embodiment of the present disclosure.

Referring to FIG. 2, a radiated noise reduction device 100 may include at least one compensation loop 101 and a circuit part 102. Although the compensation loop 101 according to an embodiment is illustrated in FIG. 2 as having a circular shape, the compensation loop 101 may have various shapes in other embodiments as long as the compensation loop 101 forms a loop when point A and point B are connected. For example, in the embodiment of FIG. 2, the compensation loop 101 is wound once, but in other embodiments, the compensation loop 101 may be wound a plurality of times.

In addition, according to an embodiment of the present disclosure, the compensation loop 101 may be a loop through which all or a portion of radiated noise emitted from the radiated noise source 200 of the electronic device 200 passes. More specifically, as described above with reference to FIG. 1, the radiated noise source 200 may generate radiated noise. In this case, according to an embodiment, a planar or three-dimensional space inside the loop formed by the compensation loop 101 may be formed such that at least a portion of the radiated noise emitted from the radiated noise source 200 passes therethrough.

According to a more specific embodiment, as illustrated in FIG. 2, the compensation loop 101 may be provided in a shape surrounding a portion or all of the radiated noise source 200. That is, the radiated noise source 200 may be located inside the loop formed by the compensation loop 101, and the compensation loop 101 may be provided in a form completely surrounding the radiated noise source 200. In this case, the radiated noise reduction device 100 may effectively cancel radiated noise generated by the radiated noise source 200. Alternatively, in another embodiment, unlike FIG. 2, the inside of the loop formed by the compensation loop 101 may have a form that surrounds or covers only a portion of the radiated noise source 200.

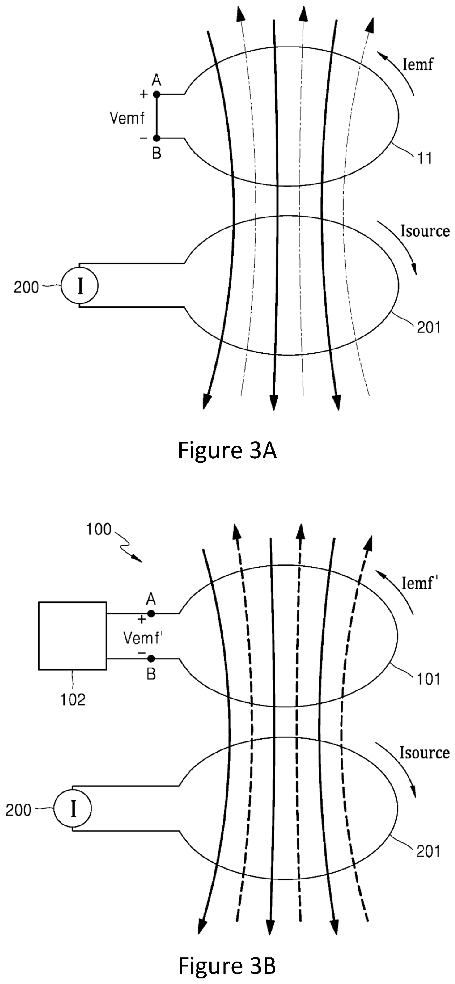

FIGS. 3A and 3B illustrate operations of the radiated noise reduction device and the radiated noise source according to an embodiment of the present disclosure.

First, in the embodiments of FIGS. 3A and 3B, for convenience of description, a case is illustrated in which the radiated noise source 200 is located at a lower side in a three-dimensional space, a shorted loop 11 is located at an upper side in FIG. 3A, and the radiated noise reduction device 100 is located at an upper side in FIG. 3B.

According to a specific embodiment, FIGS. 3A and 3B illustrate that the radiated noise source 200 includes a source loop 201 and is located on a lower plane, and that the shorted loop 11 and the radiated noise reduction device 100 are located on an upper plane. The lower plane and the upper plane may be substantially parallel to each other, but are not necessarily limited thereto.

In addition, as shown in FIGS. 3A and 3B, it may be seen that a source current Isource of the radiated noise source 200 flows along the source loop 201 in a clockwise direction when viewed from above. In the present disclosure, for convenience of description, the radiated noise source 200 is illustrated as including the loop-shaped source loop 201 through which the source current Isource flows, and radiated noise radiated downward according to the flow direction of the source current Isource is illustrated as being generated (as shown by the solid arrows directed downward in FIGS. 3A and 3B). However, the emitted radiated noise is not limited to the examples illustrated in FIGS. 3A and 3B, and the radiated noise may be emitted in various directions according to the shape of the radiated noise source 200.

First, the embodiment in which the shorted loop 11 is formed above the radiated noise source 200 as illustrated in FIG. 3A will be described. According to an embodiment, the shorted loop 11 may be an electric wire loop having a loop inductance L with respect to point A and point B. In addition, according to an embodiment, the source loop 11 may be a circuit in which point A and point B are changed from an open state to a shorted state. That is, FIG. 3A illustrates that point A and point B of the source loop 11 are shorted while the radiated noise source 200 is located on the lower plane.

In this case, since a downward magnetic field is generated by the radiated noise source 200 inside the source loop 201 and the shorted loop 11, an induced electromotive force Vemf may be generated between point A and point B of the shorted loop 11. That is, according to Lenz's law, the induced electromotive force Vemf may be generated in a direction that cancels a change in the magnetic field, and accordingly, as illustrated in FIG. 3A, an eddy current Iemf may flow in a counterclockwise direction. In addition, a magnetic field directed upward may be generated by the eddy current Iemf, as illustrated by the upward dotted arrows in FIG. 3A.

In the embodiment described above with reference to FIG. 3A, a relationship between the induced electromotive force Vemf and the eddy current Iemf may be expressed as Iemf = Vemf/sL. That is, an impedance viewed from point A and point B of the shorted loop 11 may be defined as a short-circuit impedance sL. That is, when the shorted loop 11 has an inductance L, a magnetic field generated by the eddy current Iemf (i.e., an upward magnetic field) may partially cancel a magnetic field generated by the radiated noise source 200, thereby obtaining a radiated noise reduction effect.

Meanwhile, in the embodiment of FIG. 3B, as in FIG. 3A, the source current Isource flows along the source loop 201 of the radiated noise source 200, and radiated noise radiated downward according to a flow direction of the source current Isource is illustrated as being generated. In addition, it may be seen that the radiated noise reduction device 100 is provided above the radiated noise source 200. As illustrated in FIG. 3B, the radiated noise reduction device 100 may include the circuit part 102 and the compensation loop 101. According to an embodiment, similar to the shorted loop 11 of FIG. 3A, the compensation loop 101 may be an electric wire loop having a loop inductance L with respect to point A and point B. In this case, the loop inductance L may be a previously measured or preset value.

In the embodiment of FIG. 3B, the compensation loop 101 is illustrated as having substantially the same shape as the loop area of the source loop 201 located below. However, the compensation loop 101 is not necessarily limited thereto and may be provided in any form capable of effectively canceling radiated noise emitted by the radiated noise source 200. According to an embodiment, the compensation loop 101 may be provided in a form that surrounds or covers a portion or all of the radiated noise source 200.

More specifically, a voltage between point A and point B, which are connection points between the circuit part 102 and the compensation loop 101 of the radiated noise reduction device 100, may be denoted by Vemf'. In this case, a current Iemf' may flow through the compensation loop 101 by the voltage Vemf' applied between the two points. According to an embodiment of the present disclosure, the circuit part 102 may include a negative impedance converter, and flow directions of Isource and Iemf' may be opposite to each other. In addition, according to an embodiment of the present disclosure, radiated noise generated by Iemf' (indicated by upward arrows) and radiated noise generated by Isource (indicated by downward arrows) may have directions opposite to each other.

More specifically, as described above with reference to FIG. 3A, the impedance of the shorted loop 11 may be sL. According to an embodiment of the present disclosure, the radiated noise reduction device 100 may be a circuit in which the same shorted loop 11 is used as the compensation loop 101, point A and point B of the compensation loop 101 are opened, and the circuit part 102 is connected between point A and point B. As described above, the circuit part 102 may include a negative impedance converter, and thus the impedance of the circuit part 102 may be set to -sL.

According to an embodiment of the present disclosure, since the impedance of the compensation loop 101 is sL, when the impedance of the circuit part 102 is -sL, the total impedance of the radiated noise reduction device 100 may become 0. That is, the current Iemf' flowing through the radiated noise reduction device 100 and the voltage Vemf' applied between point A and point B may be expressed as Iemf' = Vemf'/(sL-sL). Accordingly, as the eddy current Iemf' is maximized, the cancellation magnetic field may also be maximized, and thus radiated noise may be canceled or reduced. That is, the downward arrows illustrated in FIG. 3B (i.e., external magnetic field generated by the radiated noise source 200, that is, the radiated noise) may be canceled by the upward arrows (i.e., the cancellation magnetic field generated by the radiated noise reduction device 100).

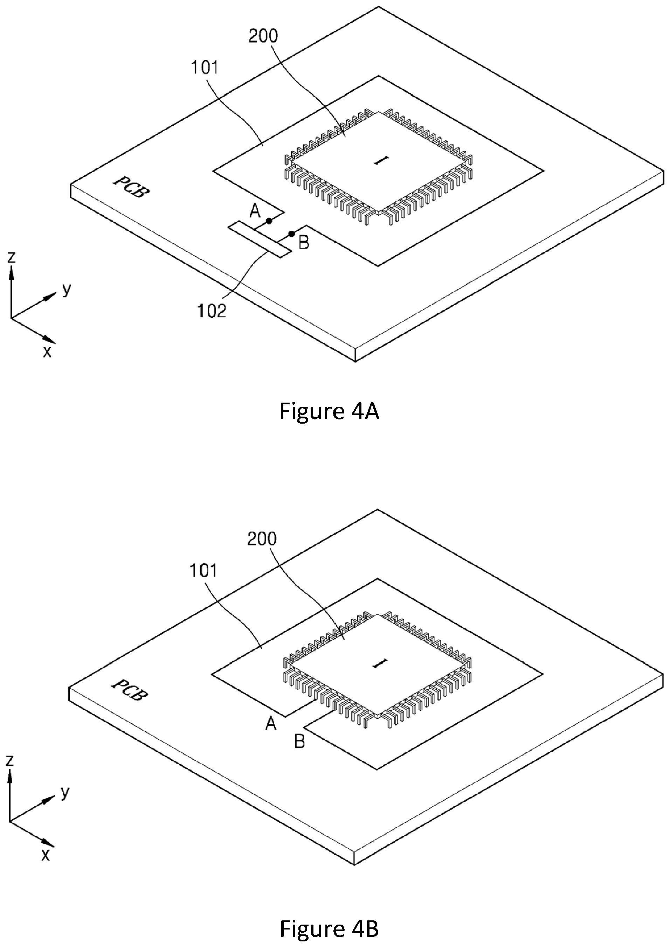

FIGS. 4A to 6B are views illustrating active radiated noise reduction devices according to other embodiments of the present disclosure.

FIGS. 4A to 6B are modified embodiments of FIG. 2 described above, and redundant descriptions will be omitted.

First, FIG. 4A is a view illustrating that the compensation loop 101 and the circuit part 102 of the radiated noise reduction device are present on one circuit board PCB, and that the radiated noise source 200 is present in a circuit board area inside the loop formed by the compensation loop 101. That is, according to an embodiment, the radiated noise source 200 may be present on the circuit board, and the compensation loop 101 may be provided to surround the radiated noise source 200. In this case, a minimum distance by which the compensation loop 101 and the source 200 are spaced apart from each other may be 5 mm or more, but the present disclosure is not necessarily limited thereto.

FIG. 4B is a modified example of FIG. 4A and illustrates that the compensation loop 101 of the radiated noise reduction device 100 is present on one circuit board PCB, but unlike FIG. 3A, the circuit part 102 is not separately present outside and is present inside the radiated noise source 200. That is, according to the embodiment of FIG. 4B, since a circuit capable of canceling radiated noise is present inside the radiated noise source 200, the radiated noise reduction device may itself cancel radiated noise passing through the compensation loop 101.

Meanwhile, according to another embodiment of the present disclosure, the compensation loop 101 and the radiated noise source 200 may be present on the same plane or on the same circuit board as in FIG. 2 or FIG. 3, but the present disclosure is not limited thereto, and the compensation loop 101 and the radiated noise source 200 may also be located on different planes.

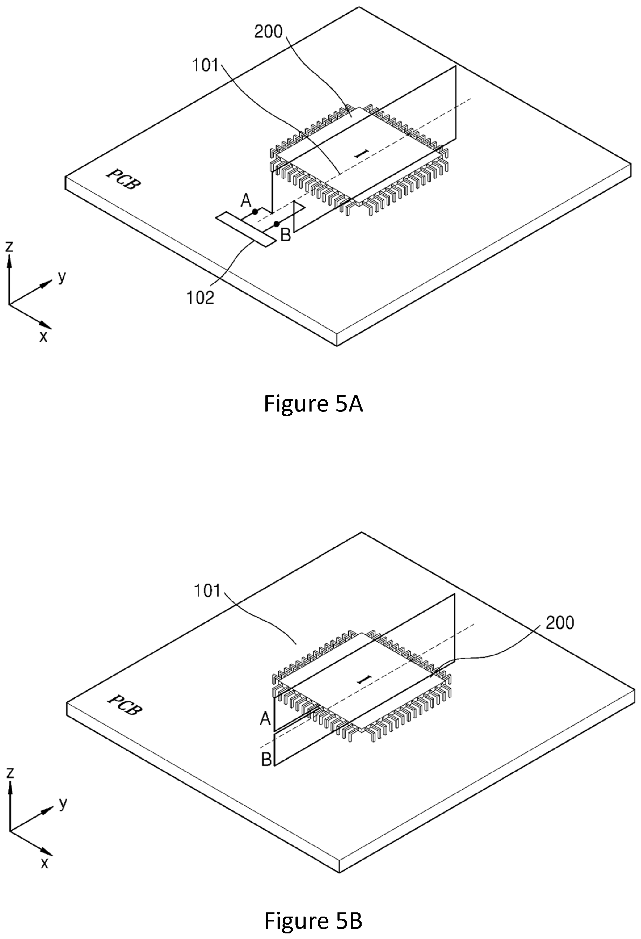

FIGS. 5A to 6B illustrate examples in which the compensation loop 101 and the radiated noise source 200 are located on different planes according to an embodiment of the present disclosure. Since FIGS. 5A to 6B are modified examples of FIGS. 4A and 4B, repeated descriptions will be omitted.

More specifically, in FIG. 5A, the circuit board PCB and the radiated noise source 200 may be present on an x-y plane, and the compensation loop 101 may be present on a y-z plane perpendicular to the circuit board PCB. In this case, the circuit part 102 may be present on the same plane as the circuit board PCB. In addition, in FIG. 5B, as in FIG. 4B, a circuit connected to the compensation loop 101 may be present in the radiated noise source 200, and the circuit may cancel radiated noise by itself using the compensation loop 101 located on the y-z plane.

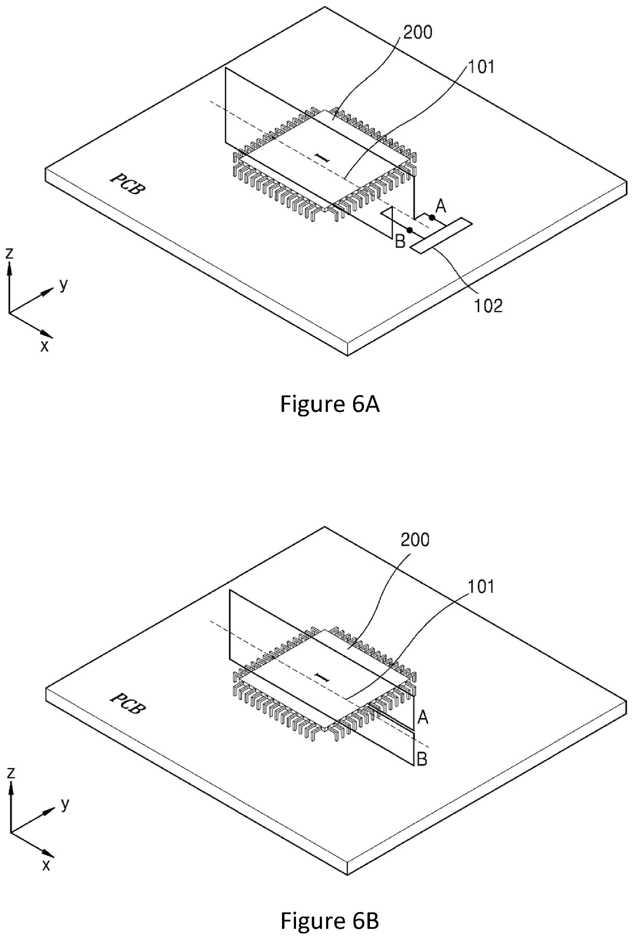

In addition, in FIG. 6A, the circuit board PCB and the radiated noise source 200 may be present on the x-y plane, and the compensation loop 101 may be present on an x-z plane perpendicular to the circuit board PCB. In this case, the circuit part 102 may be present on the same plane as the circuit board PCB. In addition, in FIG. 6B, as in FIG. 4B, a circuit connected to the compensation loop 101 may be present in the radiated noise source 200, and the circuit may itself cancel radiated noise using the compensation loop 101 located on the x-z plane.

According to the embodiments of FIGS. 5A to 6B, although the radiated noise source 200 and the compensation loop 101 are disposed on different planes, the radiated noise source 200 is present in an inner area of the loop formed by the compensation loop 101, and thus radiated noise emitted from the radiated noise source 200 may be canceled. In this regard, in the embodiments of FIGS. 4A and 4B, radiated noise emitted in a z-axis direction may be effectively canceled, in the embodiments of FIGS. 5A and 5B, radiated noise emitted in an x-axis direction may be effectively canceled, and in the embodiments of FIGS. 6A and 6B, radiated noise emitted in a y-axis direction may be effectively canceled.

In the above-described embodiments, examples in which the compensation loop of the active radiated noise reduction device and the radiated noise source are disposed on the same plane, on planes parallel to each other, or on planes perpendicular to each other have been described. However, according to another embodiment of the present disclosure, an angle formed between the compensation loop and the radiated noise source may be freely determined. That is, since the active radiated noise reduction device of the present disclosure may cancel radiated noise passing through the inside of the compensation loop, an angle of the compensation loop capable of effectively reducing radiated noise may be freely selected.

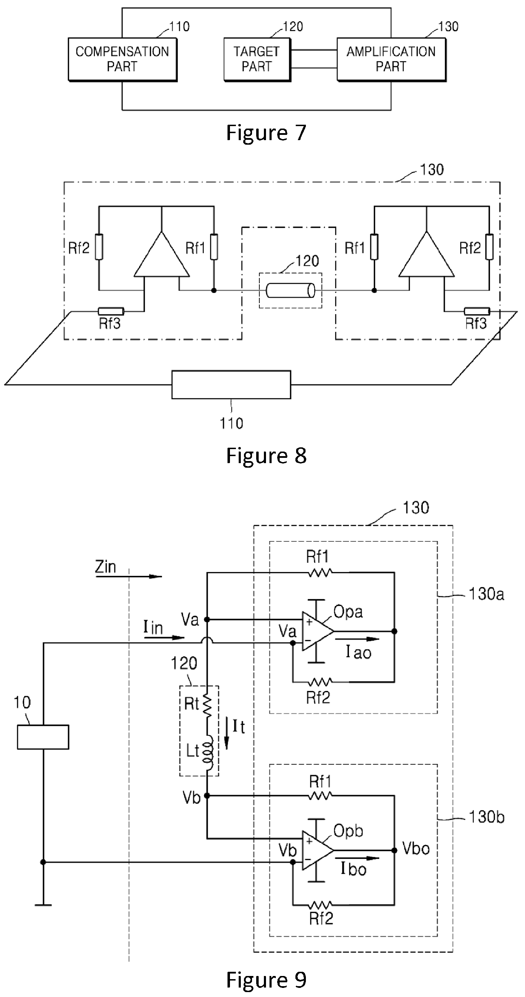

FIG. 7 is a block diagram illustrating the radiated noise reduction device 100 according to an embodiment.

First, a compensation part 110 is a configuration corresponding to the compensation loop 101 of FIG. 3B and may serve to cancel radiated noise generated by the radiated noise source 200. In addition, a target part 120 and an amplification part 130 are configurations corresponding to the circuit part 102 of FIG. 3B, may include a negative impedance converter, and may serve to negatively convert an impedance sL of the compensation part 110.

More specifically, an impedance Zin of the target part 120 and the amplification part 130 viewed from the compensation part 110 may be a negatively inverted value -sL of the impedance sL of the compensation part 110. That is, a value obtained by amplifying the impedance Zt of the target part 120 by the amplification part 130 may be the negatively inverted value -sL of the impedance sL of the compensation part 110. That is, the target part 120 and the amplification part 130 may include a negative impedance converter circuit configured to sense the impedance sL of the compensation part 110 and inversely compensate for the impedance sL. In the following embodiments of FIGS. 5 to 8, specific embodiments of the radiated noise reduction device 100 will be described.

FIGS. 8 and 9 illustrate a radiated noise reduction device according to a first embodiment of the present disclosure.

According to the first embodiment of the present disclosure, a radiated noise reduction device 100 may be implemented using two Op-amps. More specifically, referring to the embodiment of FIG. 8, a compensation part 110 is illustrated as a block. Next, the compensation part 110 may be connected to an amplification part 130, and the amplification part 130 may be connected to a target part 120. In this case, as illustrated in FIG. 8, opposite ends of the compensation part 110 may be connected to the amplification part 130 through resistors Rf3, but in another embodiment of the present disclosure, the resistors Rf3 connecting the compensation part 110 to the amplification part 130 may be omitted.

More specifically, although not specifically illustrated, the target part 120 may include one or more inductors. In addition, the amplification part 130 may include two Op-amps respectively connected to opposite ends of the target part 120, a resistor Rf1 connected to a positive input terminal of each Op-amp, and a resistor Rf2 connected to a negative input terminal of each Op-amp. That is, the negative input terminal of each Op-amp and the resistor Rf2 may be connected to one end of the compensation part 110 in parallel. In addition, the positive input terminal of each Op-amp and the resistor Rf1 may be connected to the target part 120 in parallel. In addition, the output terminal of each Op-amp may be connected to the resistor Rf1 and the resistor Rf2 in parallel.

FIG. 9 illustrates the circuit of FIG. 8 in more detail.

Referring to FIG. 9, the circuit includes the compensation part 110, the target part 120, and the amplification part 130. The total impedance of the target part 120 including a resistor Rt and an inductor Lt may be denoted by Zt.

In addition, the amplification part 130 may include a first amplification part 130a and a second amplification part 130b. The first amplification part 130a may include an Op-amp Opa and two resistors Rf1 and Rf2. More specifically, a positive input terminal of the Op-amp Opa is connected to the resistor Rf1 and the above-described target part 120. In addition, a negative input terminal of the Op-amp Opa is connected to point A of the compensation part 110 in parallel with the resistor Rf2. In addition, an output terminal Vao of the Op-amp Opa is connected in parallel with the resistor Rf1 and the resistor Rf2. That is, the output terminal Vao of the Op-amp Opa is fed back to the negative input terminal through the resistor Rf2. In addition, one end of the resistor Rf1 is connected to the target part 120, and another end thereof is connected to the output terminal Vao. One end of the resistor Rf2 is connected to point A of the compensation part 110 in parallel with the negative input terminal, and another end thereof is connected to the output terminal Vao.

Likewise, the second amplification part 130b may include an Op-amp Opb and two resistors Rf1 and Rf2. More specifically, a positive input terminal of the Op-amp Opb may be connected to the resistor Rf1 and the target part 120. In addition, a negative input terminal of the Op-amp Opb may be connected to point B of the compensation part 110 and the resistor Rf2. In addition, an output terminal vout of the Op-amp Opb may be connected to the resistor Rf1 and the resistor Rf2. In addition, one end of the resistor Rf1 may be connected to the target part 120, and another end thereof may be connected to the output terminal Vbo. In addition, one end of the resistor Rf2 may be connected to point B of the compensation part 110 and the other end of the resistor Rf2 may be connected to the output terminal Vbo.

Hereinafter, a method of calculating the input impedance Zin viewed from the compensation part 110, that is, the impedance of the target part 120 and the amplification part 130, by analyzing the circuit of FIG. 9 will be described in detail.

First, due to characteristics of the Op-amp Opa and the Op-amp Opb, it may be assumed that voltages of the positive input terminal and the negative input terminal are the same. That is, voltages of the positive input terminal and the negative input terminal of the Op-amp Opa are equal to Va. In addition, voltages of the positive input terminal and the negative input terminal of the Op-amp Opb are equal to Vb. In addition, the gain A₀ of the Op-amp Opa and the Op-amp Opa may be infinite, and the input impedance Z_{in,opamp} may also be infinite. This may be expressed by Equation 1 below. [Equation 1] $\begin{matrix}Va = {Va}^{†} \approx {Va}^{-} \\ Vb = {Vb}^{+} \approx {Vb}^{-} \\ Ao \to ∞ \\ {Z}_{in , opamp} \to ∞\end{matrix}$

Next, when a current flowing from terminal A of the compensation part 110 is denoted by Iin, and voltages of the output terminals of the Op-amp Opa and the Op-amp Opa are denoted by Vao and Vbo, respectively, the current Iin flowing through the compensation part 110 and a current It flowing through the target part 120 may be respectively represented by Equation 2 below. [Equation 2] $\begin{matrix}Iin = \frac{Va - Vao}{Rf 2} = \frac{Vbo - Vb}{Rf 2} = \frac{Va - Vb}{Zin} \\ It = \frac{Va - Vao}{Rf 1} = \frac{Vbo - Vb}{Rf 1} = \frac{Va - Vb}{Zt}\end{matrix}$

In addition, from Equation 2 above, a relationship between the input impedance Zin viewed from opposite ends of the compensation part 110 (i.e., point A and point B) and the impedance Zt of the target part 120 may be expressed as Equation 3 below. [Equation 3] $\begin{matrix}Zin \left(Va-Vao\right) = Zin \left(Vbo-Vb\right) = Rf 2 \left(Va-Vb\right) \\ Zt \left(Va-Vao\right) = Zt \left(Vbo-Vb\right) = Rf 1 \left(Va-Vb\right) \\ Va - Vb = \frac{Zt}{Rf 1} \left(Vao-Va\right) \\ Zt \left(Va-Vao\right) = Rf 2 \frac{Zt}{Rf 1} \left(Vao-Va\right) \\ Zin = - \frac{Rf 2}{Rf 1} Zt\end{matrix}$

That is, the input impedance Zin is a negatively inverted value obtained by multiplying the target impedance Zt by Rf2/Rf1. Accordingly, when the target part 120 includes an inductor, a value corresponding to the loop inductance impedance sL generated by the source 200 may be replicated as an inverted value. That is, according to an embodiment of the present disclosure, the input impedance Zin may be set to satisfy Zin = -sL by adjusting the impedance Zt of the target part 120 and the values of the resistors Rf1 and Rf2.

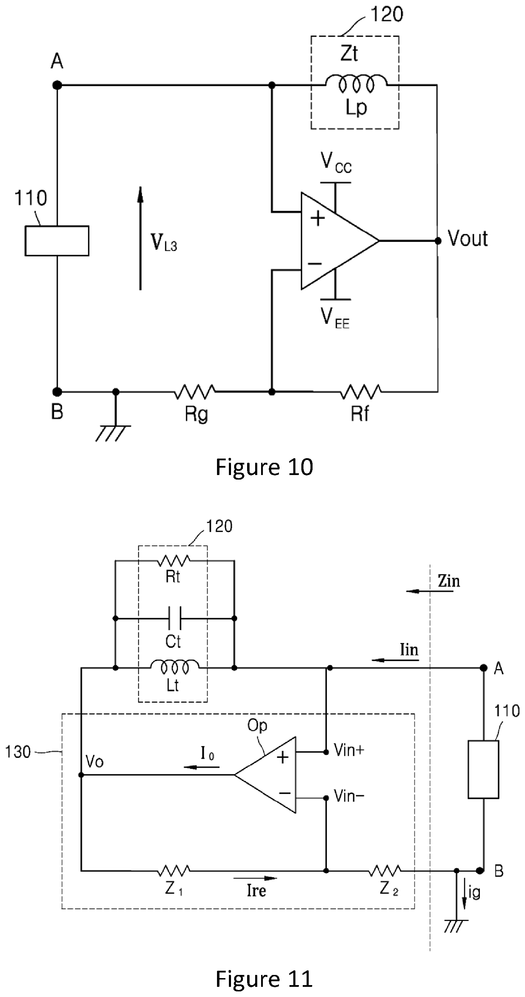

FIGS. 10 and 11 illustrate a radiated noise reduction device according to a second embodiment of the present disclosure.

A radiated noise reduction device 100 according to the second embodiment of the present disclosure may be implemented using one Op-amp. FIG. 10 is a simplified representation of a circuit according to the second embodiment of the present disclosure. First, a target part 120 may include one or more inductors Lp and may have a target impedance Zt.

More specifically, an output terminal of the Op-amp may be connected to the target part 120 and a feedback resistor Rf. In addition, a positive input terminal of the Op-amp and the target part 120 may be connected to point A of a compensation part 110 in parallel. In addition, a negative input terminal of the Op-amp and the feedback resistor Rf may be connected to one end of a ground resistor Rg in parallel. In addition, another end of the ground resistor Rg may be grounded and connected to point B of the compensation part 110. In such a circuit, the target impedance Zt of the target part 120, the feedback resistor Rf, and the ground resistor Rg may be set such that a value of the input impedance Zin becomes a value obtained by negatively converting an impedance sL of the compensation part 110.

In addition, FIG. 11 illustrates the circuit according to the second embodiment of the present disclosure in more detail. Referring to FIG. 11, the target part 120 and an amplification part 130 may be configured such that the input impedance Zin viewed from point A and point B, which are opposite ends of the compensation part 110, becomes a value obtained by negatively converting the impedance sL of the compensation part 110.

More specifically, the target part 120 may include a resistor Rt, a capacitor Ct, and an inductor Lt. In another embodiment of the present disclosure, the resistor Rt or the capacitor Ct of the target part 120 may be omitted. In addition, the amplification part 130 may include one Op-amp having a gain A0. An output terminal of the Op-amp may be connected in parallel with the target part 120 and a first on-resistance Z1. In addition, a positive input terminal of the Op-amp may be connected in parallel with the compensation part 110 and the target part 120. In addition, a negative input terminal of the Op-amp may be connected in parallel with the first on-resistance Z1 and a second on-resistance Z2. Although the first on-resistance Z1 and the second on-resistance Z2 are illustrated as including only resistors in the embodiment of FIG. 11, the first on-resistance Z1 and the second on-resistance Z2 may each be a combination of one or more resistors, capacitors, and inductors.

Subsequently, a voltage of the output terminal of the Op-amp may be denoted by Vo, a voltage of the positive input terminal may be denoted by vin+, a voltage of the negative input terminal may be denoted by vin-, and an internal impedance of the Op-amp may be denoted by Zin,opamp. In addition, when an input current is denoted by Iin and a current flowing through the first on-resistance Z1 is denoted by Ire, Iin and Ire may be represented by Equation 4 below. [Equation 4] $\begin{matrix}{v}_{o} = {A}_{o} \left({v}_{in -}-{v}_{in -}\right) , {Z}_{in , opamp} \to ∞ \\ {i}_{in} = \frac{{v}_{in +} - {A}_{o} \left({v}_{in +}-{v}_{in -}\right)}{{Z}_{t}} \\ {i}_{re} = \frac{{A}_{o} \left({v}_{in +}-{v}_{in -}\right) - {v}_{in -}}{{Z}_{1}} = \frac{{v}_{in -}}{{Z}_{2}}\end{matrix}$

Using the relationship of Equation 4 above, the process of calculating the input impedance Zin and the calculated input impedance Zin may be expressed as Equation 5 below. [Equation 5] $\begin{matrix}{A}_{o} {v}_{in +} = \left(1+{A}_{o}+\frac{{Z}_{1}}{{Z}_{2}}\right) {v}_{in -} \\ \frac{{A}_{G}}{1 + {A}_{o} + \frac{{Z}_{1}}{{Z}_{2}}} {v}_{in +} = {v}_{in -} \\ {Z}_{t} {i}_{in} = \left(1-{A}_{o}\right) {v}_{in +} + {A}_{o} {v}_{in -} \\ {Z}_{t} {i}_{in} = \left\{\left(1-{A}_{o}\right)+{A}_{o}\frac{{A}_{o}}{1 + {A}_{o} + \frac{{Z}_{1}}{{Z}_{2}}}\right\} {v}_{in -} \\ {z}_{in} = \frac{{v}_{in -}}{{i}_{in}} = \frac{{Z}_{t}}{\left(1-{A}_{o}\right) + {A}_{o} \frac{{A}_{o}}{1 - {A}_{o} + \frac{{Z}_{1}}{{Z}_{2}}}} = \frac{{Z}_{t}}{\left\{\frac{\left(1-{A}_{o}\right) \left(1+{A}_{o}+\frac{{Z}_{1}}{{Z}_{2}}\right) + {{A}_{o}}^{2}}{1 + {A}_{o} + \frac{{Z}_{1}}{{Z}_{2}}}\right\}} = \frac{{Z}_{t}}{\left\{\frac{1 - \frac{{Z}_{1}}{{Z}_{2}} - {A}_{o} \frac{{Z}_{1}}{{Z}_{2}}}{1 - {A}_{o} + \frac{{Z}_{1}}{{Z}_{2}}}\right\}} \\ {z}_{in} \approx \left(-\frac{{Z}_{2}}{{Z}_{1}}\right) {Z}_{t}\end{matrix}$

That is, Zin is a negatively converted value of (Z₂/Z₁)*Zt. Accordingly, when the value of (Z₂/Z₁)*Zt is set to be equal to the impedance sL of the compensation part 110, radiated noise generated from the source 200 may be canceled.

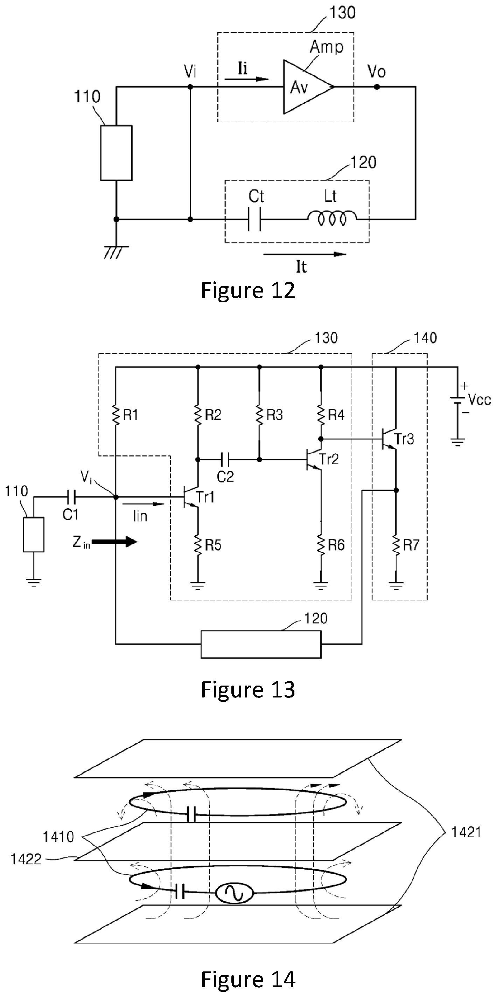

FIG. 12 illustrates a radiated noise reduction device according to a third embodiment of the present disclosure.

FIG. 12 illustrates a noise reduction circuit using an amplifier Amp. In this case, it is assumed that a gain of the amplifier Amp is Av, an input voltage is Vi, an output voltage is Vo, and an input current is Ii. In addition, in the circuit of FIG. 12, a value of a feedback impedance Zf of the amplifier Amp may be a value of a target impedance of the target part 120 (i.e., Zt = Zf). In this case, the input impedance Zin, the input voltage Vi, the input current Ii, the output voltage Vo, and the target impedance Zf may have relationships as in Equation 6 below. [Equation 6] $\begin{matrix}Vi / \left(Ii-If\right) = Zin \\ If = \left(Vi-Vo\right) / Zf \\ Vo = Av * Vi\end{matrix}$

Accordingly, referring to Equation 6, Zin and Zf may have a relationship as shown in Equation 7 below, and the value of Zf may be adjusted such that Zin becomes a negatively inverted value of the impedance sL of the compensation part 110. [Equation 7] $Ii / Vi + \left(1-Av\right) / Zf = 1 / Zin$

More specifically, when the input impedance of the amplifier Amp is set to be high to make the value of li/Vi in Equation 7 very small, the input impedance Zin may be derived as shown in Equation 8 below. [Equation 8] $Zin = \frac{Zf}{1 - Av}$

Accordingly, in Equation 8 above, when the gain of the amplifier Amp is set to 2 (i.e., Av = 2) such that the input impedance Zin becomes a negatively inverted value of the impedance sL of the compensation part 110, Zin = -Zf may be obtained. That is, the value of the target impedance Zf may be inverted in sign in a simple manner. However, the present disclosure is not limited thereto, and a negative impedance having a required magnitude may be designed through a design in which the target impedance Zf and the gain Av of the amplifier are adjusted.

FIG. 13 is a diagram illustrating a specific circuit example of the radiated noise reduction device according to the third embodiment of the present disclosure.

Referring to FIG. 13, the circuit may include a compensation part 110, a target part 120 corresponding to Zf, an amplification part 130, and an emitter follower 140.

As in the embodiment of FIG. 12 described above, an input impedance Zin viewed from the compensation part 110 may be present, and a gain Av of the amplification part 130 may be adjusted such that the input impedance Zin becomes a value obtained by negatively inverting the impedance of the target part 120. In addition, the emitter follower 140 may match a signal level of the circuit of FIG. 10 or transfer a voltage without voltage amplification. As described above, in the radiated noise reduction device as illustrated in FIG. 13, the input impedance Zin may become a value obtained by negatively converting the impedance of the target part 120 by setting the gain Av of the amplification part 130 to 2 through adjustment of values of elements R1, R2, R3, R4, R5, R6, Tr1, Tr2, and C2 inside the amplification part 130. In this regard, it should be understood that the internal element configuration of the amplification part 130 illustrated in FIG. 13 may be freely modified in design so as to set a desired value of the gain Av.

The radiated noise reduction device of the present disclosure described above may be applied to various devices and may be used to cancel or reduce radiated noise generated during operation of the devices. According to a specific embodiment, the radiated noise reduction device of the present disclosure may be applied to a wireless power transfer system.

In this regard, the term "wireless power transfer system" may collectively refer to devices and systems configured to transmit power using a high-frequency electromagnetic field, and the use of such systems has gradually expanded because power may be transmitted without a direct wired connection. However, radiated noise generated during wireless power transfer may interfere with other electronic devices and may reduce transmission efficiency. In particular, in addition to commercial wireless power devices, various problems related to radiated noise are present in home induction heaters (IH), induction-heater-based direct water purifiers, automobiles, mobile phones, industrial robot wireless power transfer systems, and the like, but regulations for such problems are generally limited to electromagnetic compatibility (EMC) testing.

In order to solve such a problem of radiated noise generation, a conventional method has been used in which radiated noise generated in a specific frequency band is reduced by adjusting a wireless power transfer frequency. However, adjusting the wireless power transfer frequency has a problem in that power transfer efficiency is reduced.

Alternatively, a conventional method has also been used in which radiated noise is reduced by using a physical shielding structure such as a metal or a magnetic absorber.

FIG. 14 illustrates an example in which shielding structures are used to reduce radiated noise.

Referring to FIG. 14, a wireless power transfer system 1410 including a transmitter Tx at a lower side and a receiver Rx at an upper side is illustrated. In this case, in order to reduce radiated noise generated in the wireless power transfer system 1410, shielding structures 1421 may be installed at upper and lower ends of the system, or a shielding structure 1422 may be installed between the transmitter Rx and the receiver Tx. However, when the shielding structures 1421 are installed at the upper and lower ends, a frequency band for power transfer is also shielded, and thus power transfer may be blocked or efficiency may be sharply reduced. Furthermore, installing the shielding structure 1422 therebetween has a problem in that power transfer becomes entirely impossible due to the principle of wireless power transfer.

In contrast, the radiated noise reduction device according to an embodiment of the present disclosure may operate as an active EMI filter (AEF) that reduces or controls EMI caused by radiated noise (or radiated emissions (RE)) in the wireless power transfer system without physical shielding or frequency change. In the following specification, for convenience of description, the circuit part of the radiated noise reduction device of the present disclosure may be referred to as an RE AEF, and the compensation part may be assumed to be a coil connected to the RE AEF.

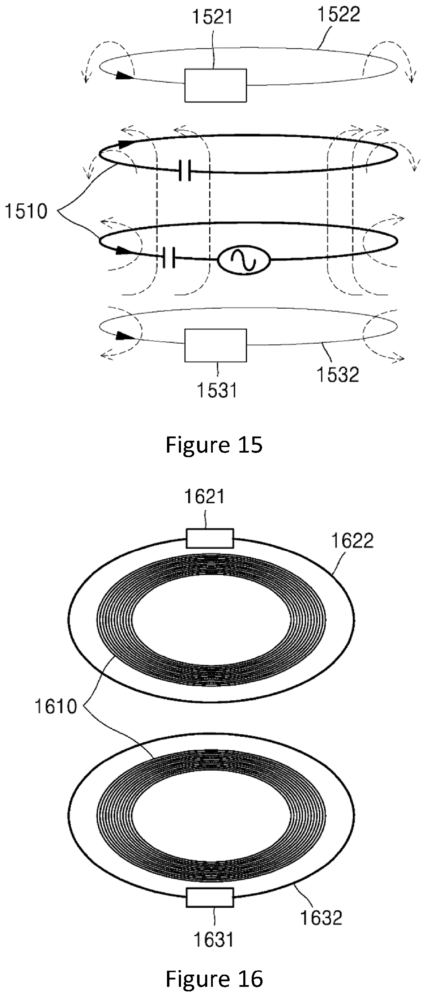

FIGS. 15 and 16 are views illustrating an example in which the radiated noise reduction device according to an embodiment of the present disclosure is applied to a wireless power transfer system.

Referring to FIG. 15, when a wireless power transfer system 1510 including a transmitter Tx at a lower side and a receiver Rx at an upper side is present, a receiver-side RE AEF 1521 and a coil 1522 may be provided above or around the receiver Rx, and a transmitter-side RE AEF 1531 and a coil 1532 may be provided below or around the transmitter Tx. That is, the radiated noise reduction device according to the embodiment of FIG. 15 may include the receiver-side RE AEF 1521 and the coil 1522, and the transmitter-side RE AEF 1531 and the coil 1532. In this case, when the embodiments of FIGS. 2 to 6 described above are also referred to, the RE AEFs 1521 and 1531 may correspond to the circuit part, and the coils 1521 and 1531 may correspond to compensation loops (or the compensation part). That is, the coils 1521 and 1531 may be provided such that all or a portion of radiated noise emitted from either the transmitter Rx or the receiver Rx of the wireless power transfer system passes therethrough.

The radiated noise reduction device according to the embodiment of FIG. 15 may operate as an active electromagnetic wave reduction circuit, and thus may allow a power transfer frequency to pass while frequency-selectively reducing only noise components in an electromagnetic interference band. That is, all or a portion of radiated noise emitted from the receiver Rx or the transmitter Tx may pass through the inside of the coils 1521 and 1531, and the radiated noise may be reduced or canceled by the radiated noise reduction device of the present disclosure.

According to an additional embodiment, although the RE AEFs 1521 and 1531 are illustrated as being provided on both the transmitter side and the receiver side in the embodiment of FIG. 15, according to another embodiment of the present disclosure, the RE AEF may be provided only on one side, particularly on a side where radiated noise is severe. In general, since radiated noise on the transmitter side may be more severe, according to an embodiment, the radiated noise reduction device may include only the transmitter-side RE AEF 1531 and the coil 1532.

FIG. 16 illustrates that, in an actual implementation example of a wireless power transfer system 1610, the wireless power transfer system 1610 is configured with coils wound a plurality of times. The upper coil and the lower coil may respectively correspond to a transmitter Tx coil and a receiver Rx coil in wireless power transfer, or vice versa. In addition, RE AEFs 1621 and 1631 and coils 1622 and 1632 of the radiated noise reduction device according to an embodiment of the present disclosure may be provided near or on the same plane as the transmitter Tx coil and the receiver Rx coil of the wireless power transfer system 1610. The coils 1622 and 1632 may be provided such that all or a portion of radiated noise emitted from either the transmitter Rx-side coil or the receiver Rx-side coil passes therethrough. For example, when the upper coil is a receiver Rx coil, the receiver-side RE AEF 1621 and the coil 1622 may be provided on the same plane as the receiver Rx coil. In this case, although the coils 1622 and 1632 are illustrated as coils wound once in FIG. 16, in another embodiment, the coils may be wound a plurality of times.

When the radiated noise reduction device according to an embodiment of the present disclosure, that is, the RE AEF, is used together with the wireless power transfer system as illustrated in FIGS. 15 and 16, a decrease in power transfer efficiency may be prevented compared to a passive shielding method. In addition, since the RE AEF is an active AEF, only a wireless power transfer frequency may be allowed to pass, and only noise components in an EMI band may be frequency-selectively reduced. For example, when an operating frequency of the wireless power transfer system is 75 kHz to 85 kHz, transfer efficiency may be maintained in the corresponding frequency band, and only an electromagnetic noise frequency band may be selectively reduced.

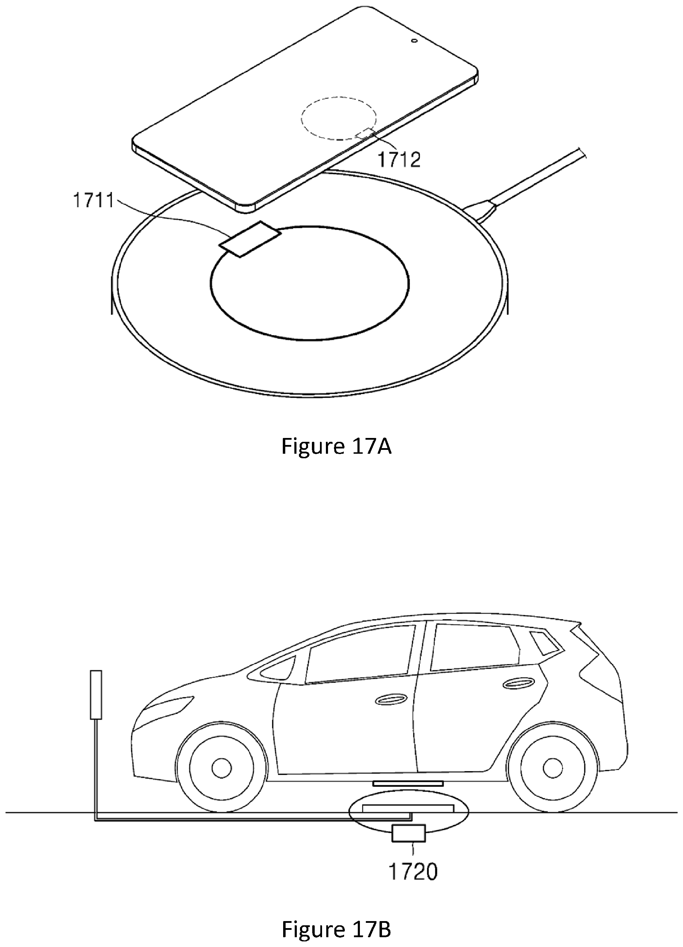

FIGS. 17A and 17B illustrate examples in which the radiated noise reduction device according to an embodiment of the present disclosure is applied to actual products.

FIG. 17A illustrates an example in which the radiated noise reduction device according to an embodiment of the present disclosure is applied to a wireless charger for a mobile phone terminal. More specifically, FIG. 17A illustrates an example in which a transmitter Tx-side RE AEF 1711 is provided inside or outside the charger, and a receiver Rx-side RE AEF 1712 is provided near a battery of the mobile phone terminal. That is, as RE AEFs are respectively provided on a charger side of the wireless charger for a portable terminal and a battery side, radiated noise may be effectively reduced.

In addition, FIG. 17B illustrates an example in which the radiated noise reduction device according to an embodiment of the present disclosure is applied to a wireless charger for an electric vehicle. More specifically, FIG. 17B illustrates an example in which a wireless power transmitter Tx-side RE AEF 1720 is provided inside or near a wireless power transmitter installed on a floor. Although not illustrated in the embodiment of FIG. 17B, a wireless power receiver Rx-side RE AEF may also be provided inside or near a receiver Rx side of the vehicle, that is, inside or near the battery. In this way, radiated noise may be effectively reduced in a wireless charging system for an electric vehicle by using the radiated noise reduction device of the present disclosure.

The present disclosure has been described with reference to one embodiment illustrated in the drawings, but this is merely exemplary, and it will be appreciated by those of ordinary skill in the art that various modifications and variations of the embodiments are possible therefrom. Accordingly, the true technical protection scope of the present disclosure should be determined by the technical spirit of the appended claims.

## Claims

1. A radiated noise reduction device for compensating for electromagnetic interference generated by a radiated noise source, the radiated noise reduction device comprising:
a compensation part including a compensation loop through which all or a portion of radiated noise emitted from the source passes; and
a circuit part connected to the compensation part and including one or more inductors and one or more amplifiers,
wherein an input impedance (Zin) of the circuit part has a value obtained by negatively converting an impedance of the compensation part.

2. The radiated noise reduction device of claim 1, wherein the compensation loop is provided to surround a portion or all of the radiated noise source such that at least a portion of the radiated noise emitted from the source passes through a planar or three-dimensional space inside a loop formed by the compensation loop.

3. The radiated noise reduction device of claim 1, wherein
the radiated noise reduction device is located on a same circuit board as the source, and
the compensation loop is provided in a form that surrounds the radiated noise source.

4. The radiated noise reduction device of claim 1, wherein a current flowing through the compensation part is a current that generates a cancellation magnetic field having a direction opposite to a direction of the radiated noise passing through the compensation loop.

5. The radiated noise reduction device of claim 1, wherein the circuit part includes:
a target part including the one or more inductors; and
an amplification part connected between the compensation part and the target part and including the one or more amplifiers.

6. The radiated noise reduction device of claim 5, wherein
the amplification part includes two Op-amps,
positive input terminals of the two Op-amps are respectively connected to opposite ends of the target part,
negative input terminals of the two Op-amps are respectively connected to opposite ends of the compensation part, and
an input impedance (Zin) is calculated based on resistors (Rf1 and Rf2), which are connected to the input terminals of the two Op-amps, and an impedance (Zt) of the target part.

7. The radiated noise reduction device of claim 6, wherein
the positive input terminals of the two Op-amps are connected to the target part and first resistors (Rf1),
the negative input terminals of the two Op-amps are connected to the compensation part and second resistors (Rf2),
output terminals of the two Op-amps are connected to the first resistors (Rf1) and the second resistors (Rf2), and
the input impedance (Zin) satisfies Zin = -(Rf2/Rf1)*Zt.

8. The radiated noise reduction device of claim 5, wherein
the amplification part includes one Op-amp,
a positive input terminal of the Op-amp is connected to one end of the target part and one end of the compensation part,
a negative input terminal of the Op-amp is connected to a first on-resistance (Z₁) and a second on-resistance (Z₂), and
when an output terminal of the Op-amp is connected to the first on-resistance (Z₁) and another end of the target part, the input impedance (Zin) satisfies Zin = -(Z1/Z2)*Zt.

9. The radiated noise reduction device of claim 1, wherein the compensation part of the radiated noise reduction device is provided such that all or a portion of radiated noise emitted from either a transmitter (Rx)-side coil or a receiver (Rx)-side coil of a wireless power transfer system passes through the compensation part.
